# EUROPEAN PATENT APPLICATION

(11) **EP 3 024 112 A1**
(43) Date of publication of application: **25.05.2016**
(21) Application number: 14825605.0
(22) Date of filing: 28.05.2014
(51) Int. Cl.: H02J 7/00

(54) **CIRCUIT SUBSTRATE AND MOBILE DEVICE EQUIPPED WITH SAME**

(30) Priority: 19.07.2013 JP 2013150194
(71) Applicant: Nitto Denko Corporation, Ibaraki-shi, Osaka 567-8680 (JP)
(72) Inventor: HATANAKA, Takezo, Ibaraki-shi Osaka 567-8680 (JP); TSUDA, Hisashi, Ibaraki-shi Osaka 567-8680 (JP)
(74) Representative: Müller-Boré & Partner Patentanwälte PartG mbB
(86) International application number: PCT/JP2014/064093
(87) International publication number: WO 2015/008543

(57) **Abstract**

Provided is a circuit substrate capable of expanding the design flexibility of a circuit configuration while facilitating the integration in circuitry.

A circuit substrate (1) includes a first processing circuit (11) and a second processing circuit (12) which is disposed at a position which may cause the first processing circuit (11) to malfunction from noises generated in association with signal processing, and comes to a halt when the first processing circuit (11) operates. The second processing circuit (12) comprises: a processing unit (121) for processing a signal; a detecting unit (123) for detecting the operation state of the first processing circuit (11); and a switching control unit (122) for switching the processing unit (121) from the operation state to the halted state only when the detecting unit (123) detects that the first processing circuit (11) is operating.

## Description

### Technical Field

The present invention relates to a circuit substrate in which noises generated during an operation of one processing circuit is kept from affecting an operation state of another processing circuit, and a mobile device equipped with such a circuit substrate.

### Background

It is generally known that noises are generated during an operation of an electronic circuit, and the noises may serve as error components in a detection signals or may be a cause of malfunctions. To effectively prevent the noise from leaking outside a device from its electronic circuit, PTL 1 discloses a structure in which an analog circuit block and a digital circuit block are disposed on separate substrates, these circuit blocks are accommodated in a conductive housing, and the housing and a ground terminal of the analog circuit block are electrically connected to each other, so as to cause the housing to function as a conductive shielding member.

### Citation List

### Patent Literatures

[PTL 1] Japanese Unexamined Patent Publication No. 2006-87523

### Summary of Invention

### Technical Problem

There have been devised in various ways to prevent leakage of noises attributed to operations of an electronic circuit, to the outside of the device, as in PTL 1 and the like. However, as to a problem that circuit blocks disposed adjacent to each other may malfunction due to an effect from the noises, not too much has been done except for keeping the circuit blocks distant from each other so as to avoid effects of noises, or disposing the circuit blocks on separate substrates as in the case of PTL 1. Therefore, the design flexibility for arranging circuits is restricted by the noise, and it is difficult to integrate the circuit blocks within a range that the blocks are affected by the noises.

In view of the above problems, it is an object of the present invention to provide a circuit substrate capable of expanding the design flexibility of a circuit configuration while facilitating the integration in circuitry, and a mobile device equipped with such a circuit substrate.

### Solution to Problem

An aspect of the present invention is a circuit substrate comprising: a first processing circuit; and a second processing circuit which is disposed at a position which may cause the first processing circuit to malfunction from noises generated in the second processing circuit in association with signal processing, and comes to a halt state when the first processing circuit operates.

In the above structure, the second processing circuit comes to a halt state when the first processing circuit operates. Therefore, the noises generated in association with the signal processing in the second processing circuit does not cause the first processing circuit to malfunction, even when the second processing circuit is disposed in a position close to the first processing circuit. This allows the first processing circuit and the second processing circuit to be arranged close to each other, and expands the design flexibility of circuit arrangements.

The circuit substrate of the above aspect may be adapted so that the second processing circuit comprises: a processing unit configured to process signals; a detecting unit configured to detect an operation state of the first processing circuit; and a switching control unit for switching the processing unit from the operation state to a halt state only when the detecting unit detects that the first processing circuit is operating.

With the above structure, a circuit having a necessary function for the second processing circuit is formed with a simple circuit structure.

The circuit substrate of the above aspect may be adapted so that: the first processing circuit comprises a rectifier unit configured to rectify an AC power supplied from outside and output a DC power, and a charger unit configured to supply the DC power output from the rectifier unit to a secondary battery at a charging voltage; and in the second processing circuit, the processing unit serves as a transformer circuit configured to execute signal processing which converts a charged power of the secondary battery into a driving power and outputs the driving power for a driving device, the detecting unit serves as a detecting circuit configured to output a detection signal indicating the first processing circuit is in the operation state, based on the DC power output from the rectifier unit, and the switching control unit serves as a switching control circuit by which the processing unit is switched to the halt state when the detection signal is input, and is switched back to the operation state when input of the detection signal ends.

The above structure realizes a high-density charging/discharging circuit with a simple structure, which does not malfunction due to a noise.

The circuit substrate of the above aspect may be adapted so that the first processing circuit and the second processing circuit each include at least one of a digital signal processing circuit and analog signal processing circuit.

The above structure facilitates formation of a high-density circuit structure including both the first processing circuit and the second processing circuit.

The circuit substrate of the above aspect may be adapted so that the first processing circuit and the second processing circuit are each formed by an analog/digital hybrid integrated circuit in which a digital signal processing circuit and an analog signal processing circuit are integrated.

The above structure improves the design flexibility, at a time of integrating circuit substrates.

Another aspect of the present invention is a mobile device comprising the above-described circuit substrate. Thus, with the present invention, a downsized and weight-reduced mobile device is obtainable.

The mobile device may further include a power-receiving module which is configured to receive power from the outside by a resonance phenomenon, and the circuit substrate may be arranged in a magnetic field space formed by the resonance phenomenon, the magnetic field space having a smaller magnetic field strength than that in other portions.

In the above structure, because the power-receiving module to which power is supplied by the resonance phenomenon is provided in the mobile device, a space part having a small magnetic field is generated at around the power-receiving module, and this space part is effectively used as the arrangement location of the circuit substrate. With this, even in the mobile device in which it is difficult to ensure an arrangement place of a circuit substrate, the arrangement place of the circuit substrate is easily ensured and hence the downsizing of the mobile device is realized.

### Advantageous Effects of Invention

The present invention provides a circuit substrate capable of expanding the design flexibility of a circuit configuration while facilitating the integration in circuitry.

### Brief Description of Drawings

[FIG. 1] FIG. 1 is a schematic block diagram of a circuit substrate.
[FIG. 2] FIG. 2 is a detailed block diagram of the circuit substrate.
[FIG. 3] FIG. 3 is a circuit block diagram of the circuit substrate.
[FIG. 4] FIG. 4 is a block diagram of a charging system.
[FIG. 5] FIG. 5 is an explanatory diagram of a schematic structure of an ear-hook hearing aid.
[FIG. 6A] FIG. 6A is a plan view of a module component.
[FIG. 6B] FIG. 6B is a front elevation of the module component.

### Description of Embodiments

### (Circuit Substrate: Overview)

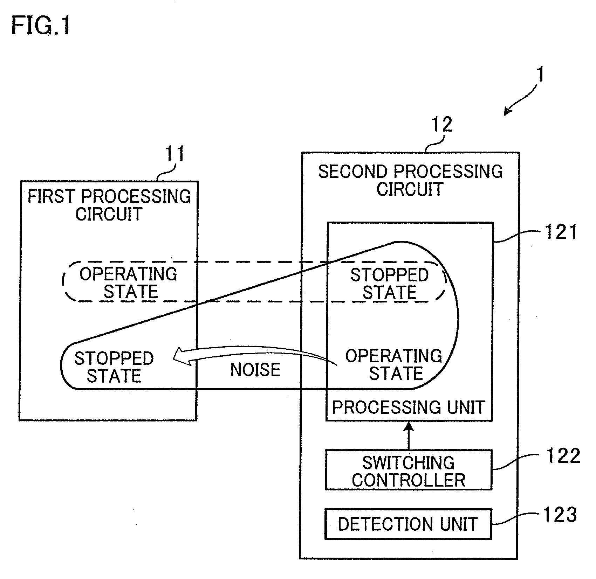

A circuit substrate of the present embodiment is structured so that noises generated during an operation of one processing circuit are kept from affecting an operation state of another processing circuit. That is, as shown in FIG. 1, the circuit substrate 1 includes a first processing circuit 11 and a second processing circuit 12 which is disposed at a position which may cause the first processing circuit 11 to malfunction from noises generated in the second processing circuit in association with signal processing, and comes to a halt state when the first processing circuit 11 operates. The expression "signal processing" herein means processing of signals such as optical signals, audio signals, electromagnetic signals, electric signals and the like, and encompasses at least one of analog signal processing and digital signal processing.

In the circuit substrate 1 having the above structure, the second processing circuit 12 comes to a halt state when the first processing circuit 11 operates. Therefore, the noises generated in association with the signal processing in the second processing circuit 12 does not cause the first processing circuit 11 to malfunction, even when the second processing circuit 12 is disposed in a position close to the first processing circuit 11. This allows the first processing circuit 11 and the second processing circuit 12 to be arranged close to each other, and allows counting out of the effects of noises between the first processing circuit 11 and the second processing circuit 12 from the design parameters, thus enabling expansion of the design flexibility of circuit arrangements.

The second processing circuit 12 in the circuit substrate 1 includes: a processing unit 121 for processing a signal; a detecting unit 123 for detecting the operation state of the first processing circuit 11; and a switching control unit 122 for switching the processing unit 121 from an operation state to a halt state only when the detecting unit 123 detects that the first processing circuit 11 is operating. With this, the circuit substrate 1 realizes a function necessary in the second processing circuit 12, with a simple circuit structure.

The first processing circuit 11 and the second processing circuit 12 each includes at least one of a digital signal processing circuit and analog signal processing circuit. That is, the first processing circuit 11 may be formed by any one of the digital signal processing circuit and the analog signal processing circuit, or may be formed by both of the circuits. Further, the second processing circuit 12 may be formed by any one of the digital signal processing circuit and the analog signal processing circuit, or may be formed by both of the circuits, as in the case of the first processing circuit 11. This way, the circuit substrate 1 facilitates formation of a high-density circuit structure including both the first processing circuit 11 and the second processing circuit 12.

Further, the first processing circuit 11 and the second processing circuit 12 are each preferably formed by an analog/digital hybrid integrated circuit in which a digital signal processing circuit and an analog signal processing circuit are integrated. This way, the design flexibility at a time of integrating the circuit substrate 1 is improved, and further downsizing and weight-reduction will be possible by forming the circuit substrate 1 as a single-chip.

The circuit substrate 1 structured as described above may be a circuit for processing a high-frequency signals or a low-frequency signals, a processing circuit for conversion of digital signals into analog signals or vice versa, a processing circuit for converting a frequency, or a processing circuit for converting an energy level. Alternatively, the circuit substrate 1 may be a charging circuit for rectifying an AC power and charging a secondary battery, a power-supplying circuit for supplying power from the secondary battery to an external device at a predetermined voltage, or a charging/discharging circuit for performing both the charging process and the power-supplying process.

### (Circuit Substrate: Charging/Discharging Circuit)

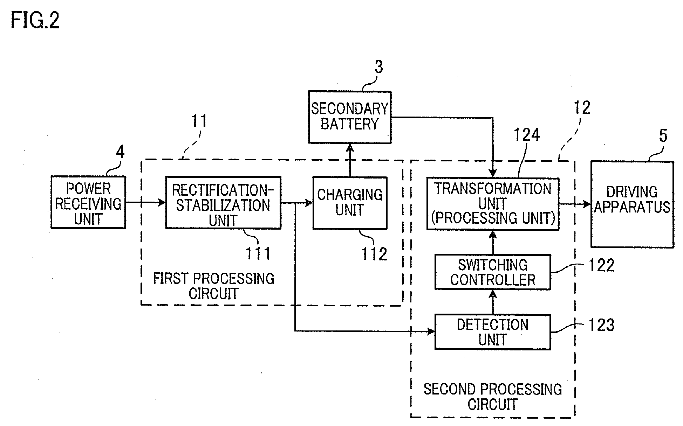

The following describes a case of applying the above-described circuit substrate 1 to a charging/discharging circuit. As shown in FIG. 2, the first processing circuit 11 of the circuit substrate 1 is connected to a power reception unit 4 configured to output an AC power, and a secondary battery 3 capable of both being charged with a power and discharging a power. The power reception unit 4 employs either wired power supply or wireless power supply. Examples of the wireless power supply include electromagnetic induction and electromagnetic field resonance. As the secondary battery 3, any type of batteries which are chargeable and rechargeable can be used. Examples of the secondary battery 3 include a lead storage battery, a valve-regulated lead storage battery, a lithium air battery, a lithium ion battery, a lithium ion polymer battery, a lithium iron phosphate ion battery, a lithium-sulfur battery, a lithium titanate battery, a nickel-cadmium storage battery, a nickel-hydrogen rechargeable battery, a nickel-iron battery, a nickel-lithium battery, a nickel-zinc battery, a rechargeable alkali battery, a sodium-sulfur battery, a redox flow battery, a zinc-bromine flow battery, and a silicon battery.

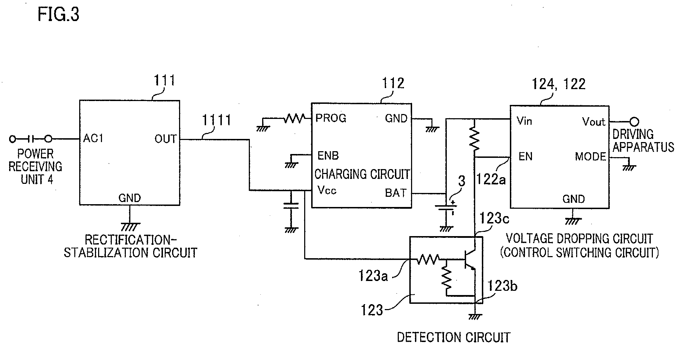

The first processing circuit 11 includes: a rectifier unit 111 configured to rectify an AC power supplied from outside via the power reception unit 4 and output a DC power, and a charger unit 112 configured to supply the DC power output from the rectifier unit 111 to the secondary battery 3 at a charging voltage. More specifically, as shown in FIG. 3, a rectification-stabilization IC may be used as this rectifier unit 111. The rectification-stabilization IC is an IC in which functions such as full bridge synchronous rectification, voltage conditioning and wireless power control, and protection from a voltage, current, or temperature anomaly are integrated into one chip. Further, the charger unit 112 is an IC for a constant current/constant voltage linear charger, and has functions such as a function of notifying that the charging current has been reduced to a predetermined setting value, a function of ending the charging using a timer, a function of stabilizing the charging current by means of thermal feedback, and a function of limiting the chip temperature in a high-power mode or in high ambient temperatures.

On the other hand, as shown in FIG. 2, the second processing circuit 12 in the circuit substrate 1 includes: a processing unit 124 for processing a signal; a detecting unit 123 for detecting the operation state of the first processing circuit 11; and a switching control unit 122 for switching the processing unit 124 from an operation state to a halt state only when the detecting unit 123 detects that the first processing circuit 11 is operating.

The processing unit 124 is a transformer circuit which functions as a transformation unit performing signal processing of converting the charged power of the secondary battery 3 to the driving power for the driving device 5 and outputting the converted power. The driving device 5 can by any types of devices which are driven by an electric power, such as a motor, a speaker, a light emitter, a display, and the like. As the transformer unit, as shown in FIG. 3, a linear regulator may be employed for voltage dropping, or a switching regulator may be employed for voltage boosting and voltage dropping. It should be noted that each of these regulators are such that their currents are turned on or off at a high-speed by a semiconductor element, and generates a high-frequency noise that could lead to malfunction of a surrounding circuit, at a time of turning on/off.

As shown in FIG. 2, the detecting unit 123 serves as a detecting circuit configured to output a detection signal indicating the first processing circuit 11 is in the operation state, based on a DC power output from the rectifier unit 111. The detecting circuit may be formed by an analog circuit such as a transistor. To be more specific, as shown in FIG. 3, the detecting unit 123 connects a base terminal 123a of a NPN transistor to an output power line 1111 between the rectifier unit 111 and the charger unit 112, and connects an emitter terminal 123b to the ground. Furthermore, as a collector terminal 123c is connected to the positive side of the secondary battery 3 via a resistor, a high impedance state is achieved, and connection to the collector terminal 123c to an input terminal 122a of the switching control unit 122 is achieved.

As a result, when the rectifier unit 111 does not output DC power, the base terminal 123a of the detecting unit 123 is in the low level and the emitter terminal 123b and the collector terminal 123c are not electrically connected with each other, with the result that a high-level detection signal is input to the input terminal 122a of the switching control unit 122. In the meanwhile, when DC power is supplied from the rectifier unit 111 to the charger unit 112'via the output power line 1111, the base terminal 123a is in the high level, and hence the collector terminal 123c and the emitter terminal 123b are electrically connected with each other and the signal at the collector terminal 123c is changed to a low-level detection signal at a ground potential. As a result, the low-level detection signal is input to the input terminal 122a of the switching control unit 122. The detecting unit 123 may be formed by a digital circuit.

The switching control unit 122 is a switching control circuit which sets the processing unit 124 to the halt state when the low-level detection signal is input, and sets the processing unit 124 to the operation state when the high-level detection signal is input (i.e., when the low-level detection signal is not input). While in the present embodiment, the low-level detection signal is used as a condition of stopping the processing unit 124 and the high-level detection signal is used as a condition of operating the processing unit 124, the disclosure is not limited to this arrangement and the low-level detection signal may be used as a condition of activating the processing unit 124 and the high-level detection signal may be used as a condition of stopping the processing unit 124.

This way, in the circuit substrate 1 of the charging/discharging circuit, the timing of the processing unit 124 such as a switching regulator and the like possibly generating a noise is synchronized with the timing at which the first processing circuit 11 is brought to a halt, and this enables formation of a simply structured high-density charging/discharging circuit in which the first processing circuit 11 does not malfunction due to the noise of the second processing circuit 12. The circuit substrate 1 of the charging/discharging circuit may be employed in transportation machines such as cars, motorbikes, and an airplanes, or may be employed in a later-described mobile device.

### (Circuit Substrate 1: Charging/Discharging Circuit: Charging System)

Next, the following describes a case where the circuit substrate 1 of the charging/discharging circuit structured as described above is applied to a mobile device 6.

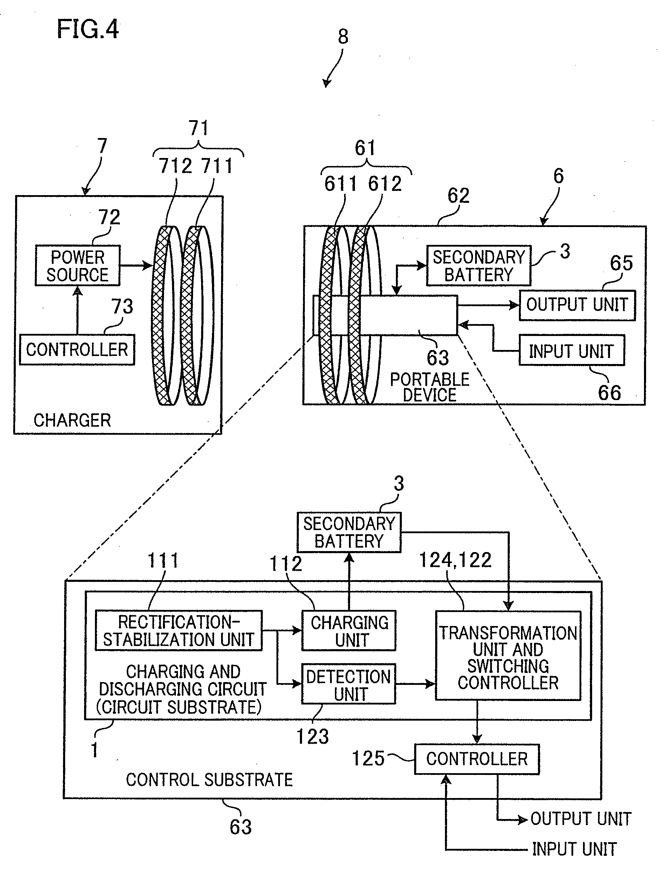

As shown in FIG. 4, the mobile device 6 includes: a power-receiving module 61 to which power is supplied from outside by means of resonance phenomenon, a secondary battery 3, and the circuit substrate 1 of the above-described charging/discharging circuit. The resonance phenomenon indicates that two or more coils are resonated at a resonance frequency. The mobile device 6 arranged in this manner is charged by a charging system 8. The charging system 8 includes a mobile device 6 having the power-receiving module 61, and a charging device 7 having a power-supplying module 71 configured to supply power by means of resonance phenomenon to the power-receiving module 61 of the mobile device 6.

### (Mobile Device 6)

The above mobile device 6 includes the secondary battery 3 configured to supply operation power, an output unit 65 such as a speaker, a light emitting member, a display, and the like, and an input unit 66 such as a microphone, a switch and the like, and a control substrate 63. The control substrate 63 is connected to the output unit 65 and the input unit 66 and has a function of outputting a control signal to the output unit 65, a function of receiving an input signal from the input unit 66, and a function of processing different types of information and data corresponding to the use of the mobile device 6.

The control substrate 63 including the circuit substrate 1 and the control unit 125 is provided in a magnetic field space which is formed by the resonance phenomenon to have a lower magnetic field strength than other parts. To put it differently, the mobile device 6 generates a space part having a small magnetic field at or around the inner side of the power-receiving module 61 when power supply using the resonance phenomenon is carried out, and this space part is used as an arrangement place of the control substrate 63. The control substrate 63 includes the circuit substrate 1 of the charging/discharging circuit and the control unit 125. The mobile device 6 can therefore be downsized because malfunction and generation of heat equal to or higher than a predetermined temperature are prevented as the generation of an Eddy current by a magnetic field at the control substrate 63 provided in the space part is restrained. Details of the space part having a low magnetic field strength will be given later. In addition to the control substrate 63, the secondary battery 3, the output unit 65, and the input unit 66 may also be provided in the space part (magnetic field space).

The power-receiving module 61 of the mobile device 6 includes a power-receiving resonance coil 611 and a power-taking coil 612. Examples of the types of coils used as the power-receiving resonance coil 611 and the power-taking coil 612 include a spiral type, a solenoid type, and a loop type.

The mobile device 6 encompasses all types of handheld devices and wearable devices (devices attached to a human body). Specific examples of the mobile device include a portable computer (a laptop PC, a note PC, a tablet PC, or the like), a camera, an audio visual device (a mobile music player, an IC recorder, a portable DVD player, or the like), a calculator (such as a pocket computer and an electronic calculator), a game console, a computer peripheral (a portable printer, a portable scanner, a portable modem, or the like), a dedicated information device (an electronic dictionary, an electronic notebook, an electronic book, a portable data terminal, or the like), a mobile communication terminal, a voice communication terminal (a mobile phone, a PHS, a satellite phone, a third party radio system, an amateur radio, a specified low power radio, a personal radio, a citizen radio, or the like), a data communication terminal (a mobile phone, a PHS (a feature phone and a smart phone), a pager, or the like), a broadcasting receiver (a television receiver and a radio), a portable radio, a portable television receiver, a one-seg receiver, another type of device (a wristwatch and a pocket watch), a hearing aid, a handheld GPS, a security buzzer, a flashlight/pen light, a battery pack, and an extracorporeal device (such as a sound processor and an audio processor) of an intracochlea implant system. Examples of the hearing aids include ear-hook hearing aids, ear-hole hearing aids, and glasses-like hearing aids.

### (Charging Device)

The charging device 7 which is configured to charge the mobile device 6 arranged as above includes a not-shown charging stand on which the mobile device 6 can be mounted. The charging device 7 further includes a power-supplying module 71 configured to supply power by the resonance phenomenon to the mobile device 6 mounted on the charging stand. The power-supplying module 71 includes a power-supplying resonance coil 711 and a power supply coil 712. Examples of the types of coils used as the power-supplying resonance coil 711 and the power supply coil 712 include a spiral type, a solenoid type, and a loop type. The charging device 7 further includes a power source unit 72 configured to supply AC power to the power-supplying module 71 and a control unit 73 configured to control the power source unit 72.

By simply mounting the mobile device 6 on the charging stand of the charging device 7, the charging to the secondary battery 3 starts and the power supply from the secondary battery 3 of the mobile device 6 to the driving device 5 is turned off. In the meanwhile, by simply lifting up the mobile device 6 from the charging stand of the charging device 7, the charging to the secondary battery 3 is stopped and the power supply from the secondary battery 3 of the mobile device 6 to the driving components 5 is turned on.

In a manner similar to the mobile device 6, the charging device 7 may be arranged such that a space part having a small magnetic field is generated at or around the inner side of the power-supplying module 71 at the time of power supply by the resonance phenomenon, and this space part is used as an arrangement place of the power source unit 72 and the control unit 73. This arrangement makes it possible to downsize the charging device 7 in addition to the mobile device 6.

### (Space Part Having Small Magnetic Field)

Now, the space part having a small magnetic field, which is mainly used as a place where the control substrate 63 of the mobile device 6 is provided, will be detailed.

The mobile device 6 is arranged such that a space part having a small magnetic field is formed at a desired position. The formation of the space part at the desired position is achieved by suitably setting power supply conditions such as a positional relation with the charging device 7, a power-supplying state, and an internal structure.

For example, the mobile device 6 may be arranged such that, when power is supplied by the resonance phenomenon from the power-supplying resonance coil 711 of the power-supplying module 71 of the charging device 7 to the power-receiving resonance coil 611 of the power-receiving module 61, at a desired position between the power-supplying resonance coil 711 of the power-supplying module 71 and the power-receiving resonance coil 611 of the power-receiving module 61, a magnetic field space having a magnetic field strength lower than the magnetic field strengths in parts other than the desired position is formed as a space part. Because in this case the space part is generated at around the charging device 7 side of the power-receiving module 61, the leading end portion side of the outer wall member is secured as the arrangement place of the control substrate 63 as the power-receiving module 61 is disposed to be slightly closer to the rear side than the leading end portion on the charger 7 side of the outer wall member.

An example of a method of forming the space part will be detailed. When power is supplied by the resonance phenomenon from the power-supplying resonance coil 711 of the power-supplying module 71 of the charging device 7 to the power-receiving resonance coil 611 of the power-receiving module 61 of the mobile device 6, the frequency of the power supplied to the power-supplying resonance coil 711 of the power-supplying module 71 is arranged so that the direction of a current flowing in the power-supplying resonance coil 711 of the power-supplying module 71 is opposite to the direction of a current flowing in the power-receiving resonance coil 611 of the power-receiving module 61.

In the formation method above, when power transmission using the resonance phenomenon is performed, the coupling coefficient indicating the strength of the coupling between the power-supplying resonance coil 711 and the power-receiving resonance coil 611 is increased as the power-supplying resonance coil 711 of the power-supplying module 71 and the power-receiving resonance coil 611 of the power-receiving module 61 are disposed to be close to each other. When the coupling coefficient is high in this manner, the measurement of a transmission characteristic "S21" (which is a value used as an index of power transmission efficiency when power is supplied from the power-supplying resonance coil 711 to the power-receiving resonance coil 611) shows that a measured waveform has two separated peaks on the low frequency side and the high frequency side, respectively. As the frequency of the power supplied to the power-supplying resonance coil 711 is set at a frequency around the peak on the high frequency side, the direction of the current flowing in the power-supplying resonance coil 711 is arranged to be opposite to the direction of the current flowing in the power-receiving resonance coil 611, and hence the magnetic field generated on the inner circumference side of the power-supplying resonance coil 711 and the magnetic field generated on the inner circumference side of the power-receiving resonance coil 611 cancel each other out, with the result that an influence of the magnetic field is reduced on the inner circumference sides of the power-supplying resonance coil 711 and the power-receiving resonance coil 611. With this, a magnetic field space having a magnetic field strength lower than the magnetic field strengths in parts other than the inner circumference sides of the power-supplying resonance coil 711 and the power-receiving resonance coil 611 is formed as a space part.

In another method of forming a space part, for example, when power is supplied from the power-supplying resonance coil 711 to the power-receiving resonance coil 611 by the resonance phenomenon, the frequency of the power supplied to the power-supplying resonance coil 711 is set so that the direction of the current flowing in the power-supplying resonance coil 711 is identical with the direction of the current flowing in the power-receiving resonance coil 611.

According to the method above, when power transmission using the resonance phenomenon is performed, the coupling coefficient indicating the strength of the coupling between the power-supplying resonance coil 711 and the power-receiving resonance coil 611 is increased as the power-supplying resonance coil 711 and the power-receiving resonance coil 611 are disposed to be close to each other. When the coupling, coefficient is high in this manner, the measurement of the transmission characteristic shows that a measured waveform has two separated peaks on the low frequency side and the high frequency side, respectively. As the frequency of the power supplied to the power-supplying resonance coil 711 is set at a frequency around the peak on the low frequency side, the direction of the current flowing in the power-supplying resonance coil 711 is arranged to be identical with the direction of the current flowing in the power-receiving resonance coil 611, and hence the magnetic field generated on the outer circumference side of the power-supplying resonance coil 711 and the magnetic field generated on the outer circumference side of the power-receiving resonance coil 611 cancel each other out, with the result that an influence of the magnetic field is reduced on the outer circumference sides of the power-supplying resonance coil 711 and the power-receiving resonance coil 611. With this, a magnetic field space having a magnetic field strength lower than the magnetic field strengths in parts other than the outer circumference sides of the power-supplying resonance coil 711 and the power-receiving resonance coil 611 is formed as a space part.

In addition to the above, the size of the space part may be set based on the strength of the magnetic coupling between the power-supplying resonance coil 711 and the power-receiving resonance coil 611, by changing adjustment parameters regarding the power-supplying resonance coil 711 and the power-receiving resonance coil 611. For example, the size of the magnetic field space is increased by relatively weakening the magnetic coupling between the power-supplying resonance coil 711 and the power-receiving resonance coil 611. In the meanwhile, the size of the magnetic field space is decreased by relatively strengthening the magnetic coupling between the power-supplying resonance coil 711 and the power-receiving resonance coil 611. As such, a space part optimum for the size of the mobile device 6 is formed.

Alternatively, the size of the magnetic field space may be changed in such a way that the arrangement relation of the power-supplying resonance coil 711 and the arrangement relation of the power-receiving resonance coil 611 are used as the adjustment parameters, and the adjustment parameters are changed to change the strength of the magnetic coupling between the power-supplying resonance coil 711 and the power-receiving resonance coil 611.

Furthermore, the shape of the space part space may be arranged to be a desired shape in such a way that the shapes of the power-supplying resonance coil 711 and the power-receiving resonance coil 611 are used as the adjustment parameters, and the shapes of these coils are changed in a desirable manner to change the strength of the magnetic coupling between and around the power-supplying resonance coil 711 and the power-receiving resonance coil 611. In this case, as the power-supplying resonance coil 711 and the power-receiving resonance coil 611 are arranged to have desired shapes, a magnetic field space having a relatively low magnetic field strength is formed with a desired shape corresponding to the shapes of the coils.

In addition to the above, the size of the space part may be set in such a way that at least one of the first distance between the power-supplying resonance coil 711 and the power supply coil 712 and the second distance between the power-taking coil 612 and the power-receiving resonance coil 611 is used as an adjustment parameter, and the size is set based on this adjustment parameter. For example, the size of the magnetic field space is increased in such a way that the first distance between the power-supplying resonance coil 711 and the power supply coil 712 and the second distance between the power-taking coil 612 and the power-receiving resonance coil 611 are relatively shortened so that the magnetic coupling is relatively weakened. In the meanwhile, the size of the magnetic field space is decreased in such a way that the first distance between the power-supplying resonance coil 711 and the power supply coil 712 and the second distance between the power-taking coil 612 and the power-receiving resonance coil 611 are relatively elongated so that the magnetic coupling is relatively strengthened.

In addition to the above, as a space part, a magnetic field space may be formed at a desired position with a magnetic field strength lower than the magnetic field strengths in parts other than the desired position, in such a manner that, a magnetic member is provided to cover at least a part of the power-receiving resonance coil 611 and the power-supplying resonance coil 711 except the surfaces where these coils oppose each other, and power transmission is carried out by changing the magnetic field between the power-supplying resonance coil 711 and the power-receiving resonance coil 611. The magnetic member may be provided to cover the inner circumferential surface of the power-receiving resonance coil 611. In this case, by blocking the magnetic field generated on the inner circumference side of the power-receiving resonance coil 611, a magnetic field space having a relatively low magnetic field strength is formed as a space part on the inner circumference side of the power-receiving resonance coil 611.

In addition to the above, the magnetic member may be provided to cover the surfaces of the power-supplying resonance coil 711 and the power-receiving resonance coil 611, which surfaces are opposite to the surfaces where the coils oppose each other. In this case, by blocking the magnetic field generated at around the surface opposite to the opposing surface of the power-receiving resonance coil 611, a magnetic field space having a relatively low magnetic field strength is formed as a space part at around the surface opposite to the opposing surface of the power-receiving resonance coil 611.

As such, the mobile device 6 is arranged such that, based on a combination of at least one of the above-described methods of forming the space part, a magnetic field space having a low magnetic field strength can be intentionally formed at will as a space part at and around the inner side of the power-receiving module 61, and the size and shape of the space part can be arbitrarily set. To put it differently, in the mobile device 6, a desired space part is formed by adjusting the way of disposing the power-receiving module 61.

### (Hearing Aids)

Now, the following will detail a case where the mobile device 6 structured as above is employed in an ear-hook hearing aid which constitutes a body mount device. While in the present embodiment, ear-hook hearing aid is taken as an example of the hearing aid, the disclosure is not limited to the same. Examples of the hearing aids include pocket-type (box-shaped) hearing aids, ear-hook hearing aids (BTE), ear-hole hearing aids (ITE), canal-type hearing aids (ITC), CIC-type hearing aids (CIC), open-ear hearing aids, RIC-type hearing aids (RIC), bone-conduction hearing aids, and embedded hearing aids.

### (Hearing Aids: Ear-Hook Hearing Aids)

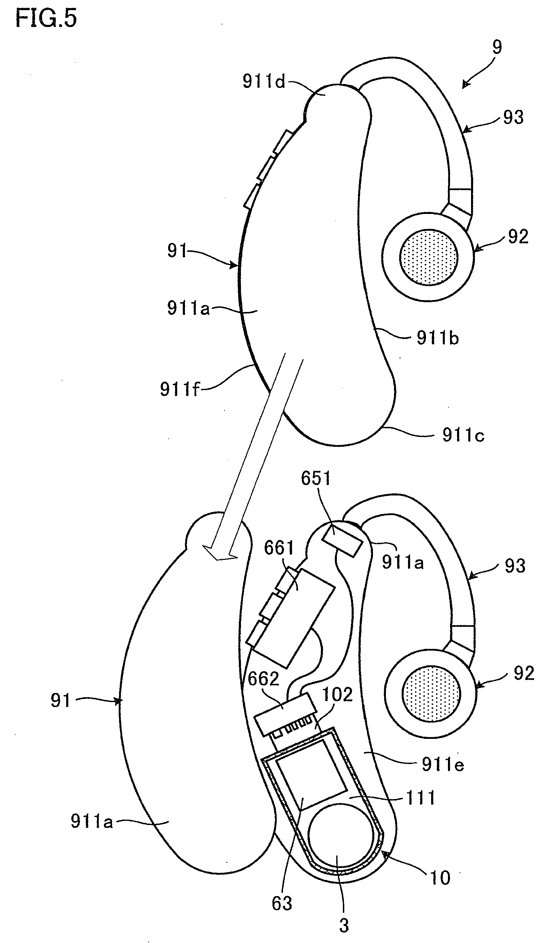

As shown in FIG. 5, the ear-hook hearing aids 9 include a hearing aid main body 91 attached to the auricle, an ear mold 92 arranged to contact with the opening of the ear hole or its surroundings, a connecting portion 93 connecting the hearing aid main body 91 with the ear mold 92, a control substrate 63 including a circuit substrate 1 of a charging/discharging circuit and a control unit 125, and an output unit 65 and an input unit 66 which are connected to the control substrate 63. The output unit 65 is constituted by a member such as a speaker 651 configured to output sound. The input unit 66 is constituted by members such as an operation button 661 for controlling sound volume and switching of the power source and a sound concentrating microphone configured to convert outside sound into an electric sound signal.

The hearing aid main body 91 has a hexahedral housing (outer wall member) which is curved from the top part to the bottom part to extend along the root of the auricle. That is to say, the housing of the hearing aid main body 91 includes an upper surface part 911d at the top part, a bottom surface part 911c at the bottom part, a head-contacting surface part 911a contacting with the head, an auricle-contacting part 911e arranged to oppose the head-contacting surface part 911a and contact with the auricle, an inner contacting surface part 911b surface-contacting with the root of the auricle along the same, and an outer surface part 911f arranged to oppose the inner contacting surface part 911b. The hearing aid main body 91 is structured to be dividable in two, i.e., into the head-contacting surface part 911a and the auricle-contacting part 911e. As such, the head-contacting surface part 911a functions as a lid whereas the auricle-contacting part 911e functions as a container.

To the upper surface part 911d of the hearing aid main body 91, one end portion of the connecting portion 93 is connected. The connecting portion 93 is a hollow tube in shape. The other end portion of the connecting portion 93 is connected to the ear mold 92. With this arrangement, the ear-hook hearing aids 9 outputs sound collected and amplified by the hearing aid main body 91 from the speaker 651 to the ear mold 92 via the connecting portion 93, and allows the user of the ear-hook hearing aids 9 to receive the sound in a clear manner.

### (Hearing Aids: Ear-Hook Hearing Aids: Module Component 10)

The ear-hook hearing aids 9 arranged as above include a module component 10 which is detachable and provided at a predetermined position. The module component 10 has a power receiving function of receiving power by the resonance phenomenon, a secondary battery function of being chargeable and dischargeable, a charging and discharging function of charging and discharging the secondary battery, and a control function of controlling the components of the ear-hook hearing aids 9.

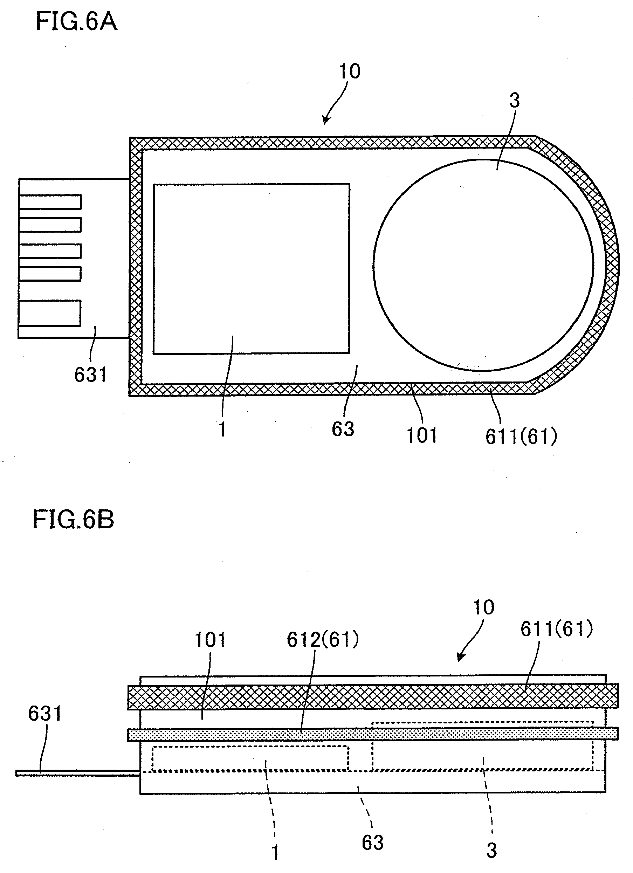

As shown in FIG. 6A and FIG. 6B, the module component 10 includes a control substrate 63 which is a flat plate in shape and a circuit substrate 1 and a secondary battery 3 both provided on the upper surface of the control substrate 63. The circuit substrate 1 may be formed as a part of the control substrate 63. The circuit substrate 1 includes the above-described rectifier unit 111 and the like and a control unit 125. Around the control substrate 63, a wall member 101 is provided. The wall member 101 is made of a conductive material such as metal. On the outer circumferential surface of the wall member 101, a power-receiving resonance coil 611 and a power-taking coil 612 are provided. The power-receiving resonance coil 611 and the power-taking coil 612 are made of a copper wire material coated by an insulation film.

As such, because the wall member 101 functioning as a magnetic member is provided to cover the inner circumferential surfaces of the power-receiving resonance coil 611 and the power-taking coil 612, the circuit substrate 1 provided on the inner circumference sides of the power-receiving resonance coil 611 and the power-taking coil 612 is arranged in a magnetic field space having a relatively low magnetic field strength. As a result, the circuit substrate 1 provided on the control substrate 63 is less influenced by a magnetic field when the power-receiving module 61 receives power.

In addition to the above, the inner circumference side of the wall member 101 is filled with solidified resin to cover the circuit substrate 1 and the mobile device 64. With this, in the module component 10, the circuit substrate 1, the secondary battery 3, and the like are less likely to be damaged by collision or water leakage.

From an end face of the control substrate 63, a terminal portion 631 protrudes. The terminal portion 631 is connected to the control unit 125, and includes a control signal terminal, a GND terminal, a power source terminal, or the like. The terminal portion 631 functions as a male connector, and a female connector 662 is detachably attached thereto. The female connector 662 is connected with an output unit 651 of the speaker and the like and an input unit 661.

With the module component 10 arranged as above, an operation to manufacture or repair the ear-hook hearing aids 9 can be completed by detaching and attaching each module component 10, and hence the manufacturing and repairing the ear-hook hearing aids 9 can be easily done in a short time. Furthermore, as the size, shape, and the terminal portion 631 of each module component 10 is standardized, various types of mobile devices including hearing aids can share the same module component 10.

While in the present embodiment the wall member 101 functioning as a magnetic member covers the circumference of the control substrate 63, the lower surface of the module component 10 (lower surface of the control substrate 63) may be further covered with a magnetic member or the top surface of the module component 10 may be further covered with a magnetic member. In such a case, each component on the control substrate 63 is arranged in a magnetic field space having a lower magnetic field strength.

In the detailed description provided above, characteristic parts have mainly been described in order that the present invention can be understood more easily. However, the present invention is not limited to the embodiment shown in the detailed description provided above, and may be applied to other embodiments. The scope of application of the present invention should be construed as broadly as possible. Further, the terms and phraseology used in the present specification are adopted solely to provide specific illustration of the present invention, and in no case should the scope of the present invention be limited by such terms and phraseology. Further, it will be obvious for those skilled in the art that the other structures, systems, methods or the like are possible, within the spirit of the invention described in the present specification. Accordingly, it should be considered that claims cover equivalent structures, too, without departing from the technical idea of the present invention. In addition, it is desirable to sufficiently refer to already-disclosed documents and the like, in order to fully understand the objects and effects of the present invention.

### Reference Signs List

1 Circuit Substrate
3 Secondary Battery
4 Power Reception Unit
5 Driving Device
6 Mobile Device
7 Charging Device
8 Charging System
9 Ear-Hook Hearing Aid
10 Module Component
11 First Processing Circuit
12 Second Processing Circuit
13 Circuit Substrate
61 Power-Receiving Module
71 Power-Supplying Module

## Claims

1. A circuit substrate, comprising:
a first processing circuit; and
a second processing circuit which is disposed at a position which may cause the first processing circuit to malfunction from noises generated in association with signal processing, and comes to a halt state when the first processing circuit operates.

2. The circuit substrate according to claim 1, wherein
the second processing circuit comprises:
a processing unit configured to process signals;
a detecting unit configured to detect an operation state of the first processing circuit; and
a switching control unit for switching the processing unit from the operation state to the halt state only when the detecting unit detects that the first processing circuit is operating.

3. The circuit substrate according to claim 2, wherein
the first processing circuit comprises
a rectifier unit configured to rectify an AC power supplied from outside and output a DC power, and
a charger unit configured to supply the DC power output from the rectifier unit to a secondary battery at a charging voltage; and
in the second processing circuit,
the processing unit serves as a transformer circuit configured to execute signal processing which converts a charged power of the secondary battery into a driving power and outputs the driving power for a driving device,
the detecting unit serves as a detecting circuit configured to output a detection signal indicating the first processing circuit is in the operation state, based on a DC power output from the rectifier unit, and
the switching control unit serves as a switching control circuit by which the processing unit is switched to the halt state when the detection signal is input, and is switched back to the operation state when input of the detection signal ends.

4. The circuit substrate according to any one of claims 1 to 3, wherein
the first processing circuit and the second processing circuit each include at least one of a digital signal processing circuit and an analog signal processing circuit.

5. The circuit substrate according to any one of claims 1 to 3, wherein
the first processing circuit and the second processing circuit are each formed by an analog/digital hybrid integrated circuit in which a digital signal processing circuit and an analog signal processing circuit are integrated.

6. A mobile device comprising the circuit substrate according to any one of claims 1 to 5.

7. The mobile device according to claim 6, further comprising
a power-receiving module which is configured to receive power from the outside by a resonance phenomenon, wherein the circuit substrate is arranged in a magnetic field space formed by the resonance phenomenon, the magnetic field space having a smaller magnetic field strength than that in other portions.
